# EUROPEAN PATENT APPLICATION

(11) **EP 2 190 017 A1**
(43) Date of publication of application: **26.05.2010**
(21) Application number: 08020224.5
(22) Date of filing: 20.11.2008
(51) Int. Cl.: H01L 27/142

(54) **High voltage semiconductor based wafer**

(71) Applicant: SAPHIRE ApS, 1820 Frederiksberg (DK)
(72) Inventor: Yakov, Safir, 1820 Frederiksberg (DK)
(74) Representative: Nielsen, Henrik Sten

(57) **Abstract**

A high voltage semiconductor based wafer, which defines a front surface for exposure to solar light and an opposite back surface. The semiconductor based wafer includes a plurality of p-n junctions each exposed to solar light at the front surface, and the plurality of p-n junctions are electrically connected in series to provide a voltage substantially higher than the voltage of a single p-n junction.

## Description

The present invention relates to a high voltage semiconductor based wafer having a plurality of solar cells and a method of producing a high voltage semiconductor based wafer having a plurality of solar cells.

In this context high voltage should be understood to mean any voltage higher than the usual voltage achieved by a conventional semiconductor based wafer, i.e. 0.3V-0.6V.

Solar cells are well known in the art of energy production for producing electric energy in an efficient and environmentally friendly way. A solar cell relies on the photovoltaic effect for generating electric energy from visual radiation, which primarily but not necessarily constitutes solar radiation. A typical solar cell consists of a thin semiconductor wafer (solar wafer) having a single large p-n junction applied on the front surface facing the light. Each of the two surfaces (front and back) of the solar cell is provided with a metal contact constituting a plus and a minus pole for providing a direct current (DC) through the semiconductor based wafer. The photons impinging on the p-n junction will excite charge carriers, which will initiate a current towards its respective pole.

The DC output current may be used directly for powering a facility or charging a battery, or alternatively a converter may be employed to convert the DC current to an AC current, which may be delivered to a transmission grid. The above type of solar cell yields a voltage of between 0.3V-0.6V and typically 0.5V whereas the voltage is weakly dependent on the amount of radiation received by the solar cell. The current is proportional to the amount of radiation received and to the solar cell area. The above applications typically need to be provided with a higher voltage than the voltage delivered by a single cell. Due to the very low voltage provided by each individual solar cell, each solar module has to contain a large amount of solar cells. For example, in a typical commercial solar module for a nominal voltage of 60V, typically 144 cells are connected in series. Therefore, to be able to achieve higher voltages a plurality of solar cells have to be connected in series to form a high voltage solar module. Typically a plurality of modules are further connected into a solar array and installed in places of high solar intensity, such as on roofs etc.

The above example assumes that each cell yields around 0.5V minus any resistive losses within the module. Solar cells for high voltage solar modules are typically made by splitting a large semiconductor based wafer into several smaller semiconductor based wafers. Since semiconductor based wafers are very brittle and fragile, the wafer may easily shiver and be damaged beyond repair.
Additionally, connecting several solar cells in series requires soldering, which is one of the major sources of malfunction in the module. By having a single nonconductive soldering point the complete module may be rendered useless. If a higher voltage is needed, even more cells need to be connected in series and a failure is even more likely. Solar cells can also be connected in parallel or be made of a semiconductor based wafer having a large area. In both cases serious problems occur, since the resulting high DC current will either result in large resistance losses and thereby high risk of short circuit or require very thick cables with thick isolation caps.

It is further known from US 5,665,175 to make a bifacial semiconductor wafer for a solar cell having a thin plate of either mono-crystalline or poly-crystalline silicon, being either p-type, n-type or intrinsic. The plates are made out of large blocks or rods of silicon by laser sawing. An n-type material, such as phosphor (P) or gallium (Ga) is diffused on one surface of the wafer for form a p-n- junction. It is further known from US 5,665,175 to diffuse a p-type material to the opposite surface of the semiconductor wafer to achieve a bifacial solar cell. Such n-type material may e.g. be boron (B) or arsenic (As).

From US 6,423,568 it is known to fabricate a silicon solar cell having p-doped regions and n-doped regions on the same side. The p-doped regions are electrically connected to form one pole of the solar cell and the n-doped regions are electrically connected to form the opposite pole of the solar cell. From this a plurality of parallel connected cells is achieved.

However, none of the above technologies provide a semiconductor wafer yielding a voltage substantially higher than the voltage of a single p-n junction. It is therefore an object of the present invention to provide technologies for producing a solar cell consisting of a single wafer, which is capable of delivering a high voltage.

In the present context it would be beneficial to be able to include a large number of p-n junctions on the same semiconductor based wafer and connect them electrically directly on the wafer to avoid the need of splitting large cells and solder the individual cells together to achieve higher voltage. It would also be beneficial to be able to increase the area of the semiconductor based wafer without increasing the current proportionally. Both for solar cell and solar module production it would be more cost effective to produce cells having a large area.

The accurate application of fluids on a substrate has been described in WO 2006/111247. To achieve a phosphor doping, the semiconductor based wafer is firstly damped with phosphor acid. Subsequently, the phosphor acid is allowed to diffuse into the semiconductor based wafer by the use of a high temperature oven.

The above need and object together with numerous other needs and objects, which will be evident from the below detailed descriptions of preferred embodiments of the module according to the present invention, are, according to a first aspect of the present invention obtained by a high voltage semiconductor based wafer defining a front surface for exposure to solar light and an opposite back surface, said semiconductor based wafer including a plurality of p-n junctions each exposed to solar light at said front surface, said plurality of p-n junctions being electrically connected in series for providing a voltage substantially higher than the voltage of a single p-n junction.

By providing a plurality of p-n junction on the wafer, the wafer will in principle comprise a plurality of individual solar cells. The first p-n junction defines a first solar cell and the second p-n junction defines a second solar cell and so on. Surprisingly, in the present context it has been found that the individual solar cells may be applied and electrically connect with a high accuracy to form a series connection.

The series connection is understood to mean that the p region of the first p-n junction is connected to the n region of the second p-n junction etc, or the other way around, i.e. the n region of the first p-n junction is connected to the p region of the second p-n junction etc. The electrical connection may be printed or deposited on the wafer using state of the art printing or deposition technologies.

In the above-mentioned WO 2006/111247 the inkjet printing technology has been described in connection with phosphor doping. Inkjet technologies have the advantage of applying a very homogeneous layer onto the wafer. Similar technologies may be used for boron doping and for applying the conductors.

In a further embodiment according to the first aspect of the present invention the total voltage of said semiconductor based wafer is substantially equal to the voltage of a single p-n junction multiplied with the number of p-n junctions on said semiconductor based wafer. By connecting the cells in series and/or parallel the total voltage of the semiconductor based wafer may be chosen.

In a further embodiment according to the first aspect of the present invention said semiconductor based wafer comprises 2-1000 p-n junctions, preferably 10-500 p-n junctions, more preferably 50-200 p-n junctions, and most preferably 144 p-n junctions, or alternatively 50-144 p-n junctions or 144-200 p-n junctions.

Preferably 144 solar cells are connected in series to obtain a total voltage of around 60V. This way, a single wafer may replace a complete solar module, at least with respect to the voltage output. A higher voltage, and consequently lower current, compared to connecting the p-n- junctions in series, has the advantage of allowing thinner conductors on the semiconductor based wafer. Since the conductors will at least partially prevent solar radiation from reaching the p-n junction, thinner conductors on the front surface of the semiconductor based wafer will allow a more efficient semiconductor based wafer. The high voltage output is achieved without the need for any soldering, since the conductors may be printed or deposited on the semiconductor based wafer.

In a further embodiment according to the first aspect of the present invention said p-n junctions are encapsulated within said semiconductor based wafer and/or said p-n junctions are located on said front surface and/or said p-n junctions are located on said back surface.

The p-n junctions may be places on different locations on the semiconductor based wafer, i.e. several different geometries are possible. The typical placement of the p-n junctions would be at the front surface close to the incoming solar radiation. However, the back surface may as well comprise p-n junctions or p-n junctions may be encapsulated within the semiconductor based wafer. Alternatively several layers of p-n junctions may be used, or a combination of the above.

In a further embodiment according to the first aspect of the present invention said semiconductor based wafer comprises metallurgical grade silicon or metallurgical grade semiconductor material.

Typically polycrystalline silicon or monocrystalline silicon of semiconductor grade is used for the semiconductor based wafer. Low quality silicon increases the risk of impurities, which may increase the risk of failure of the solar cell. Due to the high demand on pure silicon, successful attempts have been made using high quality metallurgical grade silicon for solar cells. Metallurgical grade silicon has more impurities than semiconductor grade silicon, however, the price is significantly lower.

In a further embodiment according to the first aspect of the present invention, said semiconductor based wafer comprises bypass diodes.

The high voltage semiconductor based wafer preferably comprises bypass diodes. Bypass diodes are well known and used to allow the current to bypass a series of solar cells in case of a malfunction of a single solar cell. In some cases malfunctions cause a solar cell to draw power from the solar module or completely prevent current from flowing through the solar module. By including a bypass diode connected parallel to one or more p-n junctions, the effect of a malfunction may be limited to the loss of the p-n junctions coupled to the bypass diode. The current then flows through the bypass diode instead of through the p-n junction. The bypass diodes may preferably be used together with the above mentioned metallurgical grade silicon for reducing the risk of a total failure of the solar module due to silicon impurities. In the above context, p-n junction should be understood to mean the solar radiation receiving p-n junctions and not the p-n junction encapsulated within the diode.

In a further embodiment according to the first aspect of the present invention said semiconductor based wafer comprises:
a first p-n junction defining a first doped area of a first type and a second doped area of a second type, said first p-n junction defining a first current path,
a second p-n junction electrically isolated in relation to said first p-n junction and defining a third doped area of said second type and a fourth doped area of said first type, said second p-n junction defining a second current path, and
a metal layer for electrically connecting said first doped area and said third doped area or alternatively said second doped area and said fourth doped area so that said first and second current paths form a series connection.

The semiconductor based wafer is typically a doped silicon (Si) wafer constituting either a p-type silicon wafer or an n-type silicon wafer. The doped areas constitute areas where doping material has been introduced into the silicon typically by a diffusion process. The doping materials may be either n-type material such as phosphor (P), or p-type material such as boron (B). The specific conductivity types of the doped areas are achieved by introducing either n-type material or p-type material on the active areas.

By connecting the solar cells in series so that the first doped area of the first solar cell having a specific type is electrically connected to the third doped area of the second cell having an opposite type, the total voltage provided by the solar cell is doubled.

In the state of the art technologies each semiconductor substrate wafer was only capable of providing a voltage substantially equal to the voltage of a single solar cell. There is a high risk of cross diffusion when using two different doping materials which typically prevents including more than one p-n junction on each side of the cell. By cross diffusion is meant the electrical contamination in an active area of the first conductivity caused by atoms of the second conductivity. By having atoms of the second dopant near the first dopant, there is high risk that atoms of the second dopant may enter into the area of the first dopant during the diffusion process. Cross diffusion may occur by having direct contact between two areas of different conductivity. Cross diffusion may be avoided e.g. by ensuring a sufficient distance between the areas having different doping.

For instance, nearby boron atoms may diffuse into an area which should solely be accommodated by phosphor atoms, or vice versa. Such contamination leads to reduced efficiency or possibly a total failure of the p-n junction. In the industry, cross diffusion is avoided by having a strict separation of the n-type material and the p-type material. Further separation may be achieved by using masking layers of ultra clean oxide.

Atoms of different conductivity may also be transported by the airflow/gasflow during the high temperature step of the diffusion process. Since the doping materials normally are provided in very low concentrations, such as part per billion, even very few atoms of an opposite conductivity may cause a failure.

Surprisingly, in the present context it has been found that by following the process steps further described below, the risk of cross diffusion may be significantly reduced. Thus, a plurality of p-n junctions may be placed on the same cell without any risk of cross diffusion.

In a further embodiment according to the first aspect of the present invention said first type comprises either a boron, an arsenic or an atom group III material dopant, and said second type comprises either a phosphor, a gallium or an atom group IV material dopant.

Typically, boron and phosphor is used as doping material for the first doping type and the second doping type, respectively.

In a further embodiment according to the first aspect of the present invention said first doped area of said first type is oriented towards said front surface, said a second doped area of said second type is oriented towards said back surface, said third doped area of said second type is oriented towards said front surface and said fourth doped area of said first type is oriented towards said back surface.

The first and second solar cells having an opposite orientation, i.e. the first solar cell may constitute a p-n junction and the second solar cell may constitute a n-p junction, or vice versa. This geometry will make the subsequent electrical connection particularly simple, since it does not require a very accurate application of the conductor connecting the p-n junctions and since any laser treatment or plasma etching or chemical etching into the semiconductor based wafer is completely avoided.

In a further embodiment according to the first aspect of the present invention, third and fourth doped areas are connected to further silicon wafers, or other electrical components, by the use of substantially two soldering points for each silicon wafer.

Since the silicon wafers must not be split, substantially only two soldering points are needed to achieve a high voltage solar module. The semiconductor based wafer may be directly connected to other electrical components which are using the energy produced in the semiconductor based wafer. Such electrical components may be a battery chargers etc. For each additional semiconductor based wafer connected in series in relation to the first semiconductor based wafer, one soldering point is needed. Previous solar modules needed one soldering point for each p-n junction or alternatively for each 0.5V voltage increase. Less soldering points have the benefit of greater reliability, since soldering points are prone to causing electrical failures.

In a further embodiment according to the first aspect of the present invention, said active areas comprise a silica layer.

The doping materials are usually applied by a silica layer. The process currently used is described below:
The presently preferred process has the advantage of only requiring 2 high temperature steps, in contrast to most currently used processes needing at least 6 high temperature steps. Also, the presently preferred process does not require the use of any photoresist. The process steps are briefly summarised below:
   1. Etching of saw scratches on the wafer by using 30% Choline solution.
   2. Texturing of wafer surface by using 5% Choline solution.
   3. Rinsing of the wafer by H₂O to remove residual Choline
   4. Drying of the wafer to remove residual H₂O.
   5. Printing on phosphor silica pattern
   6. Diffusing of phosphor (high concentration) at approximately 1000C with gettering with slow cooling and plasma-etch.
   7. Printing on boron silica pattern
   8. Printing on phosphor silica pattern
   9. Diffusing of phosphor (low concentration) and boron (high concentration) at approximately 1000C and subsequent plasma-etch.
   10. Applying conductors (conductive film) on the phosphor layer and subsequently on the boron layer.

In a further embodiment according to the first aspect of the present invention, said doped areas are formed by using rapid thermal annealing.

Rapid thermal annealing is an efficient method for activating the conductive material. Rapid thermal annealing involves heating the substrate to about 1200K. Typically, a halogen lamp is used for this purpose. It should be noted that the silicon wafer should be cooled slowly to avoid any thermal damage. Typically, one heating cycle is needed for each conductive material, thus two heating cycles are needed for two concoctive materials.

In a further embodiment according to the first aspect of the present invention said first type dopant is applied before said second type dopant.

In this context it has been experimentally shown that when using boron and phosphor as dopants, phosphor diffuses into the boron layer to a very large extent, whereas boron diffuses into the phosphor layer to a much lesser extent. Thus, by applying and diffusing boron into the silicon wafer before applying and diffusing phosphor into the silicon wafer, the effect of cross diffusion may be significantly reduced. Further reduction of cross diffusion is achieved by covering the silicon wafer during the heat treatment. Yet further reduction of cross diffusion is achieved by ventilation.

In a further embodiment according to the first aspect of the present invention, said doped areas are applied by the use of screen printing or alternatively by the use of inkjet printing.

Typically, spin-on is used as a simple and fast method for applying the p-type and n-type material on the silicon wafer. However, spin-on is not suitable for applying different types of conductive material on the same surface, since spin-on covers the whole surface with an equally thick layer of material. Screen printing and inkjet printing are technologies which are used for very accurate application of a material onto a surface. Both screen printing an inkjet printing allows a precise quantity and positioning of the doping material on the wafer surface and allows different conductive materials to be positioned on different parts of the same surface. The accuracy is decisive for achieving the correct functionality of the solar cells and therefore both screen printing and inkjet printing may be used.

In the present context inkjet printing is preferred, since both the dopant and the electrical connectors may be applied by inkjet printing.

The above need and object together with numerous other needs and objects, which will be evident from the below detailed descriptions of preferred embodiments of the module according to the present invention, are, according to a second aspect of the present invention obtained by method of producing a high voltage solar cell wafer, said method comprising:
providing a wafer, preferably crystalline silicon, defining a front surface for exposure to solar light and an opposite back surface,
applying a plurality of p-n junctions each exposed to solar light at said front surface,
connecting said plurality of p-n junctions electrically in series for providing a voltage substantially higher than the voltage of a single p-n junction

It is evident that the above method according to the second aspect of the present invention may include any of the features according to the first aspect of the present invention. It is further evident that all of the embodiments described in connection with the first aspect of the present invention may equally apply to the second aspect of the present invention.

The present invention will now be further described with reference to the drawings, in which:
Fig 1a-b is a square semiconductor based wafer from a front and side view, respectively
Fig 2a-b is a bifacial circular semiconductor based wafer from a front and back view Fig 2c is a single sided circular semiconductor based wafer from a front view
Fig 3a-c is a screen printing pattern.
Fig 4 is a semiconductor based wafer where the p-n junctions are located on the front surface.
Fig 5 is a semiconductor based wafer where the p-n junctions are encapsulated, and
Fig 6 is a semiconductor based wafer where the p-n junctions are oriented perpendicular to the front surface.

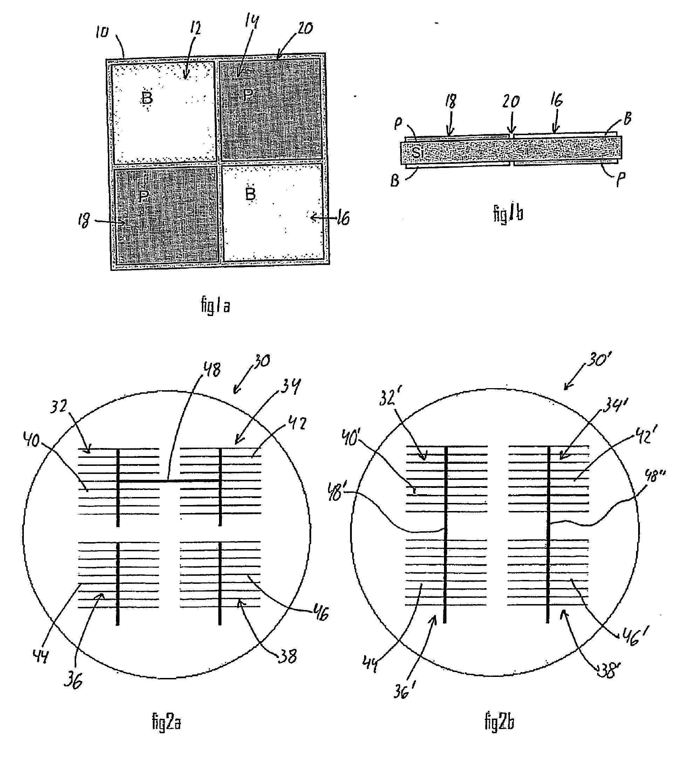

Fig 1 a shows a front surface view of a square semiconductor based wafer 10 according to the present invention. The semiconductor based wafer 10 comprises four p-n junctions. The semiconductor based wafer 10 will thus yield four times the voltage compared to a standard single p-n junction wafer. The front surface of the semiconductor based wafer has four square and equally sized doped areas 12, 14, 16, 18. Two of the doped areas 12, 16 constitute p-type silicon material and the other two doped areas 14, 18 constitute n-type material. The n-type doped areas have been doped with phosphor (P) atoms, while the p-type doped areas have been doped with boron (B) atoms. The four doped areas 12, 14, 16, 18 are arranged in two rows and two columns, each row and column comprising an n-type doped area and a p-type doped area, respectively. The four doped areas 12, 14, 16, 18 are thus arranged in an alternating pattern, i.e. each of the two n-doped areas 14, 18 are arranged adjacent to the two p-type areas 12, 16 and each of the two p- type areas 12, 16 are arranged adjacent to the two n-type areas 14, 18 so that a chess board pattern is formed. The rows and columns of the four doped areas 12, 14, 16, 18 are separated by a small strip 20 of non-doped silicon material, so that no direct contact between the four doped areas 12, 14, 16, 18 is present.

Fig 1b shows a side view of the previously described square silicon wafer 10 according to the present invention. The current view shows both the front surface and the back surface of the silicon wafer 10. The present view reveals the back surface of the silicon wafer 10, which has a pattern of doped areas representing a mirror image of the front surface. Each of the doped areas on the front surface has an oppositely doped area on the back surface, i.e. an area of n-type material on the front surface has an opposite area of p-type material on the back surface and each of the doped areas on the front side having p-type material have an opposite area of n-type on the back surface. Thus, the silicon wafer 10 wafer comprises four solar cells 12, 14, 16, 18 in which two of the solar cells 12, 16 are oppositely oriented compared to the other two solar cells 14, 18.

On p-type silicon, the design consists of an alternation between p+pn+ and n+pp+ areas, where the phosphorous emitter is on the front and back of the wafer, respectively. By using a boron back-surface field, the semiconductor based wafer becomes transparent so that, when the emitter is on the bottom of the silicon wafer, light may pass into the solar cell, and when the emitter is on the top of the silicon wafer, non-absorbed light may be reflected back into the semiconductor based wafer.

The present technology involves using both p-type and n-type doped areas 12, 14, 16, 18. The n-type doped areas 14, 18 are applied by diffusing phosphor (n-type material) atoms into the silicon wafer 10 and n-type doped areas 12, 16 are similarly applied by diffusing boron (p-type material) atoms into the silicon wafer 10. The process steps used has been described above. A technique based on screen printing has been developed for the area-selective application of boron and phosphorus diffusion sources. The diffusion may be performed by rapid thermal annealing, as already discussed above.

The silicon wafer 10 may alternatively be an intrinsic silicon wafer. Thus, the doped areas 12 and 16 will be doped with p-type material (boron atoms) on the front surface and n-type material (phosphor atoms) on the back surface. Alternatively, an n-type wafer may be used for achieving n+np+ and p+nn+ cells.

Fig 2a shows the front surface of a circular semiconductor based wafer 30 according to the present invention. The semiconductor based wafer 30 is made of intrinsic p-type material having four solar cells 32, 34, 36, 38 which have been produces in a similar way as described in connection with fig 1. The front surface of the solar cells designated 32 and 38 constitutes p-doped areas and the front surface of the solar cells designated 34 and 36 constitutes n-type areas. Each of the solar cells 32, 34, 36, 38 on the semiconductor based wafer has a contact grid 40, 42, 44, 46 respectively. The contact grids 40, 42, 44, 46 constitute a metal grid of tin coated copper band on top of the doped areas 32, 34, 36, 38. This technique is well known in the art of solar cell manufacturing. The individual solar cells 32, 34, 36, 38 are joined by tin coated copper band to form a series connection. On the front surface the solar cell designated 32 is electrically connected to the adjacent solar cell 34 by tin coated copper band 48

Fig 2b shows the back surface 30' of the above circular semiconductor based wafer 30. The back surface of the solar cells designated 32' and 38' constitutes n-doped areas and the front surface of the solar cells designated 34' and 36' constitutes p-type areas. The back surface the solar cells designated 32' is electrically connected to the adjacent solar cell 36' and the solar cell 34' is electrically connected to the adjacent solar cell 38' by tin coated copper band 48', 48" respectively. Thus, the four solar cells 32, 34, 36, 38 are electrically connected by a series connection which effectively yields a total voltage of the semiconductor based wafer 30' as the voltage of a single cell multiplied with the number of cells which in this case is four.

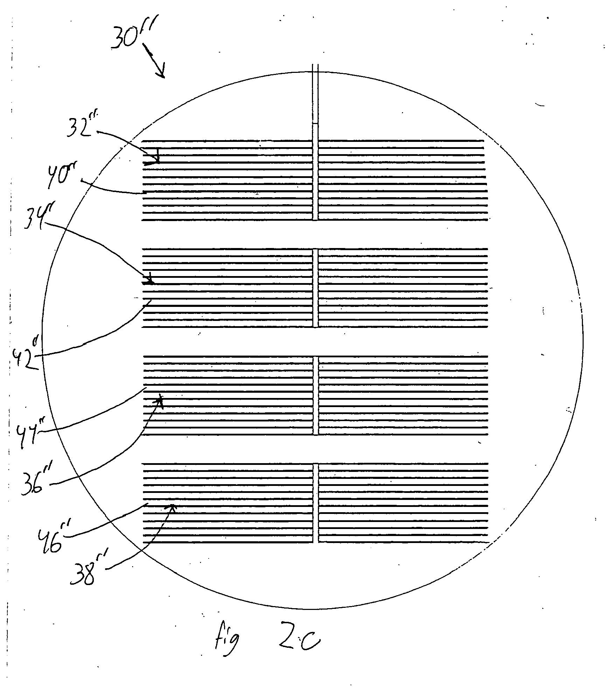

Fig 2c shows a single sided circular semiconductor based wafer 30". The back surface of the solar cells designated 32" and 36" constitutes n-doped areas and the front surface of the solar cells designated 34" and 3'8' constitutes p-type areas forming an alternating pattern. The four solar cells 32", 34", 36", 38" are electrically connected by a series connection which effectively yields a total voltage of the semiconductor based wafer 30" as the voltage of a single cell multiplied with the number of cells which in this case is four. The four solar cells 32", 34", 36", 38" are electrically connected by contact grids 40", 42", 44", 46" which constitute a metal grid of tin coated copper band of one 1 mm band in the longitudinal direction and twelve 0.1 mm bands in the transversal direction for each solar cell 32", 34", 36", 38".

The maximum voltage is provided on the front surface of the above circular silicon wafer 30 between solar cell 36 and 38. To avoid cross diffusion, a small distance should be left without doping between the solar cells 32, 34, 36, 38.

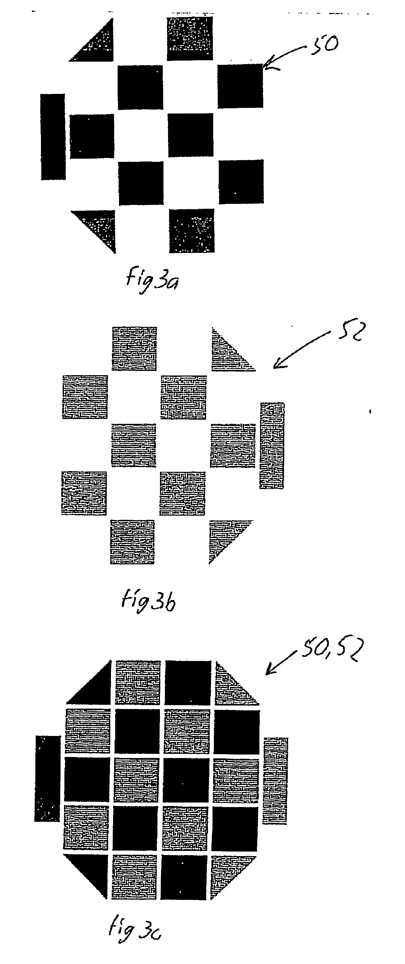

Fig 3 shows a silicon wafer comprising a plurality of p-type and n-type areas. The p-type and n-type material may be applied by using screen printing. The material used for screen printing is a silica material comprising either boron or phosphor atoms for creating either p-doped areas or n-doped areas, respectively.

Fig 3a shows the pattern 50 used for printing boron silica material, fig 3b shows the pattern 52 for printing phosphor silica and fig 3c shows the result from printing both the boron pattern 50 of fig 3a and the phosphor pattern 52 of fig 3b. To avoid cross diffusion between the boron and phosphor layers, a small undoped area is left between the boron and phosphor areas.

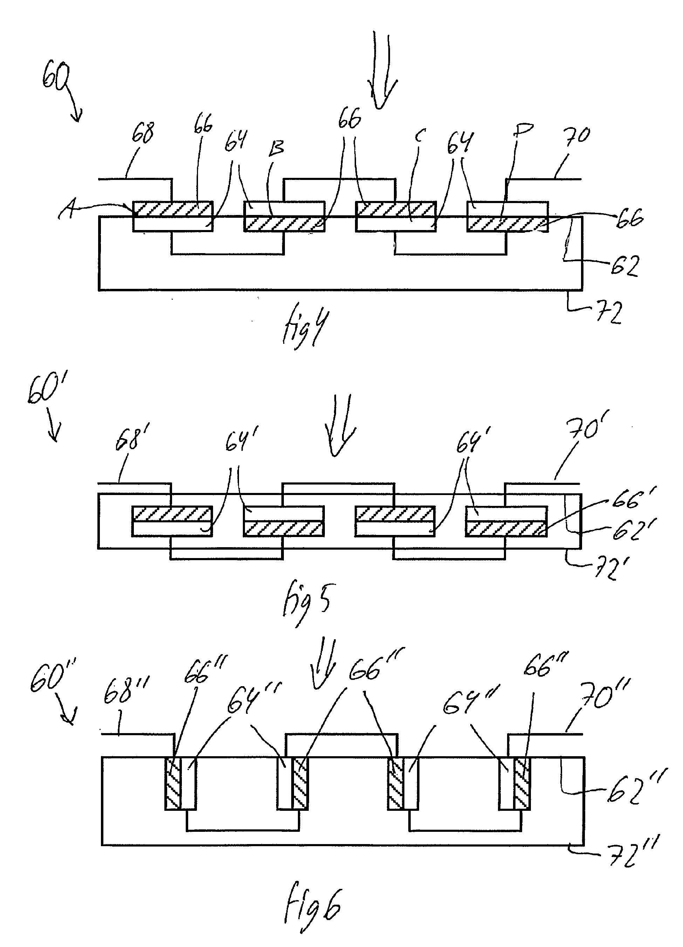

Fig 4 shows a single sided semiconductor based wafer 60 comprising a silicon wafer. The semiconductor based wafer 60 comprises a front surface 62 having alternating layers of boron 64 and phosphor 66 forming 4 p-n junctions, where 2 p-n junctions have the boron 64 layer facing upwards and the phosphor 66 layer facing downwards, and 2 p-n junctions having the boron 64 layer facing downwards and the phosphor 66 layer facing upwards. The p-n junctions are connected in series by a conductor 68. The conductor connects the upper phosphor layer of the first p-n-junction A to the outside. The lower boron layer of the first p-n- junction is connected to the lower phosphor layer of p-n- junction B inside the semiconductor based wafer 60. The upper boron layer of p-n- junction B is connected on the surface of the semiconductor based wafer 60 to the phosphor layer of p-n junction C. The lower boron layer of p-n junction C is connected to the lower phosphor layer of p-n-junction D inside the silicon wafer 62 and finally the upper boron layer of the p-n junction D is connected to the outside at 70. The connectors 68 and 70 may be soldered to other electrical equipment for consuming the power generated by the semiconductor based wafer 60. The back surface 72 of the silicon wafer 62 may be reflective to reflect the radiation back towards the p-n- junctions.

Fig 5 shows a semiconductor based wafer 60' similar to the semiconductor based wafer 60, however in the present embodiment the boron 64' and phosphor 66' layers are completely encapsulated within the semiconductor based wafer 60'. The conductor 68' may be located on the front and back surface or alternatively inside the silicon wafer.

Fig 6 shows a semiconductor based wafer 60" similar to the semiconductor based wafer 60, however in the present embodiment the boron 64" and phosphor 66" layers are oriented perpendicular in relation to the front surface 62" of the semiconductor based wafer 60".

Although the present invention has been described above with reference to specific embodiments of the semiconductor based wafer, it is of course contemplated that numerous modifications may be deduced by a person having ordinary skill in the art and modifications readily perceivable by a person having ordinary skill in the art is consequently to be construed part of the present inventions as defined in the appending claims.

List of parts with reference to the figures:
10. Square semiconductor based wafer
12, 14, 16, 18. Doped areas
20. non doped strip
30. Circular semiconductor based wafer
32, 34, 36, 38. Doped areas
40, 42, 44, 46. Contact grid
48. Copper band
50. Boron pattern
52. Phosphor pattern
60. Semiconductor based wafer
62. Silicon wafer
64. Boron layer
66. Phosphor layer
68. First conductor
70. Second conductor
72. Reflective back surface

## Claims

1. A high voltage semiconductor based wafer defining a front surface for exposure to solar light and an opposite back surface, said semiconductor based wafer including a plurality of p-n junctions each exposed to solar light at said front surface, said plurality of p-n junctions being electrically connected in series to provide a voltage substantially higher than the voltage of a single p-n junction.

2. The method according to claim 1, wherein the total voltage of said semiconductor based wafer is substantially equal to the voltage of a single p-n junction multiplied with the number of p-n junctions on said semiconductor based wafer.

3. The semiconductor based wafer according to any of the preceding claims, wherein said semiconductor based wafer comprises 2-1000 p-n junctions, preferably 10-500 p-n junctions, more preferably 50-200 p-n junctions, and most preferably 144 p-n junctions, or alternatively 50-144 p-n junctions or 144-200 p-n junctions.

4. The semiconductor based wafer according to any of the preceding claims, wherein said p-n junctions are encapsulated within said semiconductor based wafer and/or said p-n junctions are located on said front surface and/or said p-n junctions are located on said back surface.

5. The semiconductor based wafer according to any of the preceding claims, wherein said semiconductor based wafer comprises metallurgical grade silicon.

6. The semiconductor based wafer according to any of the preceding claims, wherein said semiconductor based wafer comprises by-pass diodes.

7. The semiconductor based wafer according to any of the preceding claims, wherein said semiconductor based wafer comprises:
a first p-n junction defining a first doped area of a first type and a second doped area of a second type, said first p-n junction defining a first current path,
a second p-n junction electrically isolated in relation to said first p-n junction and defining a third doped area of said second type and a fourth doped area of said first type, said second p-n junction defining a second current path, and
a metal layer for electrically connecting said first doped area and said third doped area or alternatively said second doped area and said fourth doped area so that said first and second current paths form a series connection.

8. The semiconductor based wafer according to claim 7, wherein said first type comprises either a boron, an arsenic or an atom group III material dopant and said second type comprises either a phosphor, a gallium or an atom group IV material dopant.

9. The semiconductor based wafer according to any of the claims 7-8, wherein said first doped area of said first type is oriented towards said front surface, said a second doped area of said second type is oriented towards said back surface, said third doped area of said second type is oriented towards said front surface and said fourth doped area of said first type is oriented towards said back surface.

10. The semiconductor based wafer according to any of the claims 7-9, wherein said third and fourth doped areas are connected to further semiconductor based wafers, or other electrical components, by the use of substantially two soldering points for each semiconductor based wafer.

11. The semiconductor based wafer according to any of the claims 7-10, wherein said first type dopant is applied before said second type dopant.

12. The semiconductor based wafer according to any of the claims 7-11, wherein said active areas are applied by the use of screen printing or alternatively by the use of inkjet printing

13. A method of producing a high voltage solar cell wafer, said method comprising:
providing a wafer, preferably crystalline silicon, defining a front surface for exposure to solar light and an opposite back surface,
applying a plurality of p-n junctions each exposed to solar light at said front surface,
connecting said plurality of p-n junctions electrically in series to provide a voltage substantially higher than the voltage of a single p-n junction.

14. The method according to claim 9, further comprising any of the features of claim 2-14.
